Europäisches Patentamt

European Patent Office

Office européen des brevets

(19)

(11) Veröffentlichungsnummer : **0 014 759**
**B1**

(12) **EUROPÄISCHE PATENTSCHRIFT**

(45) Veröffentlichungstag der Patentschrift :
22.09.82

(21) Anmeldenummer : 79105179.0

(22) Anmeldetag : 14.12.79

(51) Int. Cl.³ : **H 01 L 31/18**, H 01 L 21/306,
**H 01 L 31/02**

(54) **Verfahren zum reliefartigen Strukturieren von Siliciumoberflächen.**

(30) Priorität : 05.02.79 US 9005

(43) Veröffentlichungstag der Anmeldung :
03.09.80 (Patentblatt 80/18)

(45) Bekanntmachung des Hinweises auf die Patenterteilung : 22.09.82 Patentblatt 82/38

(84) Benannte Vertragsstaaten :
DE FR GB

(56) Entgegenhaltungen :
DE A 1 621 511
DE A 2 817 072
US A 3 971 684
US A 4 131 488
US A 4 137 123

IBM TECHNICAL DISCLOSURE BULLETIN ;
Band 20, Heft 9, Februar 1978 New York
R. CAMPBELL et al. « Dendritic silicon
photothermal devices » Seiten 3 707 bis 3 708
Patents Abstracts of Japan Band 2, Heft 11,
26. Januar 1978, Seite 10 502 E 77

(73) Patentinhaber : **International Business Machines Corporation**
**Armonk, N.Y. 10504 (US)**

(72) Erfinder : **Hansen, Thomas Adrian**
**1 Clayton Place**
**Poughkeepsie, N.Y. 12603 (US)**
Erfinder : **Johnson Jr.,Claude**
**2460 Pine Grove**
**Yorktown Heights, N.Y. 10598 (US)**
Erfinder : **Wilbarg, Robert Ronald**
**19 Fenwick Drive**
**Hopewell Junction, N.Y. 12533 (US)**

(74) Vertreter : **Busch, Robert, Dipl.-Ing.**
**Schönaicher Strasse 220**
**D-7030 Böblingen (DE)**

Verfahren zum reliefartigen Strukturieren von Siliciumoberflächen

Die Erfindung betrifft ein Verfahren wie es dem Oberbegriff des Patentanspruchs 1 zu entnehmen ist. Zur direkten Umwandlung von Sonnenlicht in elektrische Energie wird im zunehmenden Maße von Siliciumsolarzellen Gebrauch gemacht, da sich hiermit bisher die besten Ergebnisse erzielen lassen. Das Problem hierbei besteht darin, unter weiterer Erhöhung des praktisch erzielbaren Wirkungsgrades eine weitestgehende Verbilligung zu erreichen, um so ein breites Anwendungsfeld zu eröffnen. Das Bemühen, diese Ziele zu erreichen, geht deshalb dahin, bei Herstellung eine weitgehende Automatisierung anzustreben und die Materialkosten zu senken, indem z.B. die Verwendung von polykristallinem oder metallurgischem Silicium ins Auge gefaßt wird.

Zur Erhöhung des tatsächlich zu erzielenden Wirkungsgrades von Siliciumsolarzellen ist es dabei von Bedeutung, daß das Reflexionsvermögen der Siliciumoberfläche weitgehend herabgesetzt wird. Dies läßt sich u.a. dadurch herbeiführen, daß die Siliciumoberfläche für den Lichteinfall aufgerauht wird bzw. mit einem nichtreflektierenden Überzug versehen wird. Bei einer derart strukturierten Oberfläche wird dabei gleichzeitig gewährleistet, daß bei weitgehendem Wiedereinfangen an sich schon reflektierten Lichtes diejenige Distanz auf ein Minimum gebracht wird, um welche die durch den Photoeffekt erzeugten Ladungsträger in die Zelle eindiffundieren müssen, bevor ein Rekombinationsvorgang stattfinden kann. Bei nichtreflektierenden Oberflächenstrukturen lassen sich so Wirkungsgrade bis zu 20 % unter Verwendung von monokristallinem Silicium erzielen, wenn auch die Energieausbeute bei Massenproduktions-Solarzellen allgemein nur um 12 % herum liegt.

Es sind mehrere Verfahren bekannt geworden, um Siliciumoberflächen durch Anwenden von Ätzverfahren aufzurauhen bzw. reliefartig zu strukturieren, nämlich aus der DE-OS 16 21 511 und aus dem Buch « Semiconductors and Semimetals », Vol. 11, « Solar Cells », im Verlag Academic Press, 1975, Seiten 225 bis 227.

Bei den beschriebenen Verfahren wird von Siliciumeinkristallen mit für den Lichteinfang vorgesehener < 100 >-Ebene ausgegangen. Auf die < 100 >-Ebene wird eine Ätzlösung zur Einwirkung gebracht, so daß dann die Lichteinfallsebene mit kleinen Pyramiden überdeckt ist, die bei < 100 >-Grundflächen jeweils vier < 111 >-Seitenflächen aufweisen. Eine mit einem derart behandelten Siliciumkristall ausgestattete Solarzelle weist ein erheblich herabgesetztes Reflexionsvermögen auf, so daß sich an sich ein besonderer Antireflexüberzug erübrigt. Es ergibt sich ferner erhöhte Ausbeute, da hierbei Ladungsträgererzeugung relativ nahe am PN-Übergang stattfinden kann. So wird das Reflexionsvermögen reinen Siliciums vom Bereich zwischen 35 bis 45 % bei glatten Oberflächen dank reliefartig strukturierter Oberfläche auf etwa 20 % herabgedrückt, wobei sich durch zusätzlich angebrachten Antireflexbelag das Reflexionsvermögen sogar noch auf einige wenige Prozent einstellen läßt.

Zur Bereitstellung von mit derartigen Pyramiden bedeckten Siliciumoberflächen kann ein Naßätzverfahren angewendet werden. Wie aber allgemein in der Halbleitertechnik bekannt, ergeben sich bei Naßätzverfahren manchmal Schwierigkeiten in der Einstellung der Betriebsparameter, speziell bedingt durch Verunreinigungen, die in der Ätzlösung auftreten können oder bei Einhaltung einer exakten Ätzeinwirkungsdauer, die erforderlich ist, um brauchbare Ergebnisse zu erzielen. Jedoch der entscheidende Nachteil bei Anwendung von Naßätzverfahren besteht darin, daß es hiermit nur möglich ist, reliefartig strukturierte Siliciumoberflächen hervorzurufen, wenn einkristallines Silicium Anwendung findet. Dies stellt bekanntlich die teuerste Siliciummodifikation dar. Deshalb ist es anstrebenswert, reliefartig strukturierte Oberflächen auch auf Silicium der Solarzellenqualität anbringen zu können, eine Siliciummodifikation, die wesentlich billiger und für Massenproduktion besser geeignet ist, als einkristallines Silicium.

Weitere an sich bekannte Ätzverfahren zum Aufrauhen von Silicium stellen Hochfrequenz-Plasmaätzung unter Verwendung von Halogenkohlenstoffmischungen, Kathodenzerstäubung mit Gleichspannung oder Hochfrequenz und Ionenstrahl-Abtragungsverfahren dar.

Bei Plasmaätzung ergibt sich eine chemische Reaktion an der zu ätzenden Materialoberfläche mit bei der Entladung auftretenden Ionen. Ein derartiges Verfahren unterscheidet sich insofern von Kathodenzerstäubung, als im ersteren Falle nur Ionenbombardement vorliegt.

Derartige sogenannte Trockenätzverfahren werden nicht nur zum Anätzen von Silicium und anderer Materialien verwendet, sondern auch zur Reinigung ihrer Oberflächen, um vorhandene Verunreinigungen zu entfernen und außerdem zum Abtragen von Schichtmaterialien, wie z.B. Siliciumdioxid oder Photolack.

Im Übrigen ist aus der US-P 3 971 684 das reaktiven Ionenätzen von Siliciumoberflächen in einer $SF_6$ enthaltenden Gasentladungskammer bekannt, um bei durch eine Maske nicht abgedeckten Siliciumoberflächenbereichen Vertiefungen mit wohl definierten Vertikalwänden in den zugehörigen Silciumkristall einzubringen.

Eingehende Untersuchungen haben jedoch gezeigt, daß weder reines Kathodenzerstäubungsätzen sowie Ionenstrahlabtragung noch Plasmaätzverfahren zu Siliciumsolarzellen führen, deren Reflexionsvermögen vergleichbar niedrig ist, wie das der mit Naßätzverfahren behandelten Siliciumsolarzellen. Speziell hat sich herausgestellt, daß eine Plasmaätzanlage bei der die Hochfrequenzenergie außerhalb der Behandlungskammer eingekoppelt wird, nicht zu dem gewünschten Erfolg führt, da die Siliciumoberfläche hierbei lediglich abgeätzt wird.

Unter diesen Voraussetzungen besteht die Aufgabe der Erfindung darin, ein Verfahren bereitzustellen, das es gestattet, mit Hilfe handelsüblicher Anlagen Siliciumoberflächen gleichgültig ob von kristallinem, amorphem oder polykristallinem Silicium mit Trockenätzverfahren reliefartig zu strukturieren, so daß sich das Reflexionsvermögen der so behandelten Oberfläche auf einen tragbaren Minimalwert herabdrücken läßt.

Erfindungsgemäß wird diese Aufgabe gelöst, wie es dem Kennzeichen des Patentanspruchs 1 zu entnehmen ist.

Die Siliciumoberfläche wird also erfindungsgemäß einem reaktiven Ionenätzverfahren ausgesetzt. Unter dem Ausdruck reaktives Ionenätzen sei verstanden, daß die Siliciumoberfläche sowohl einem Zerstäubungsvorgang als auch gleichzeitig einer chemischen Reaktion mit der im Entladungsraum vorhandenen Gasart ausgesetzt wird. Eine dieser Maßnahmen allein reicht allerdings nicht aus, den angestrebten Erfolg herbeizuführen. Zur Durchführung des Erfindungsgemäßen Verfahrens dient eine Entladungskammer, bei der Ionen beschleunigt werden.

Praktische Ergebnisse zeigen, daß sich dank Anwendung des erfindungsgemäßen Verfahrens reliefartig strukturierte Siliciumoberflächen ergeben, die dem bloßen Auge tiefschwarz und samtartig erscheinen. Bei Betrachtung mit Hilfe eines Oberflächenraster-Elektronenmikroskops zeigt sich, daß die Reliefstruktur der Siliciumoberfläche aus lauter Pyramiden besteht, ähnlich wie es nach Anwenden der oben beschriebenen Naßätzverfahren der Fall ist.

Durch Anwenden anderer Arbeitsgase als hier genannt, lassen sich ebenfalls brauchbare Reliefstrukturen auf Siliciumoberflächen herbeiführen.

Werden einkristalline Siliciumsubstrate dem erfindungsgemäßen Verfahren unterworfen, dann ergibt sich eine Herabsetzung des Reflexionsvermögens gegenüber polierten Siliciumoberflächen von 80 bis 90 %. Wird Silicium der Solarzellenqualität, wie es z.B. in Siliciumbandform vorliegt, gemäß dem Verfahren nach der Erfindung behandelt, dann ergibt sich eine Ausbeutenerhöhung bei Solarzellenanwendung von 30 bis 40 %, d.h. eine Wirkungsgraderhöhung von 8,2 bis 11 %. Soweit bekannt, liegt mit der Erfindung tatsächlich das einzige Verfahren vor, um erfolgreich reliefartig strukturierte Oberflächen auf handelsüblichem Bandsilicium hervorzurufen.

Das erfindungsgemäße Verfahren läßt sich an sich ohne Anwenden irgendwelcher Masken auf der Siliciumoberfläche benutzen, wenngleich auch Maskenanwendung dann zweckdienlich sein kann, wenn hiermit spezielle Oberflächengestaltung erreicht werden soll.

Weiterhin hat sich gezeigt, daß es für die Anwendung des erfindungsgemäßen Verfahrens gleichgültig ist, ob das Einbringen des PN-Übergangs in das Silicium vorher oder hinterher erfolgt. Zur weiteren Erhöhung der Solarzellenausbeute läßt sich schließlich noch nach Abschluß des mit dem erfindungsgemäßen Verfahren verbundenen Prozesses jeweils ein Antireflexüberzug anbringen.

Weitere Ausgestaltungen und Vorteile der Erfindung lassen sich den Unteransprüchen entnehmen.

Die Erfindung wird anschließend anhand einer Ausführungsbeispielsbeschreibung mit Hilfe unten aufgeführter Zeichnungen näher erläutert.

Es zeigen :

Figur 1 einen schematischen Querschnittsausschnitt durch einen Siliciumhalbleiter, der unter Anwenden des erfindungsgemäßen Verfahrens mit reliefartig strukturierter Oberfläche ausgestattet ist,

Figur 2 in schematischer Darstellung den Querschnitt durch ein erstes Ausführungsbeispiel einer Ätzanlage zur Durchführung des erfindungsgemäßen Verfahrens,

Figur 3 eine schematische Darstellung eines Querschnitts durch ein zweites Ausführungsbeispiel einer Ätzapparatur zur Durchführung des erfindungsgemäßen Verfahrens,

Figuren 4A bis 4C Wiedergaben von Oberflächen-Elektronenstrahl-Rasteraufnahmen der unter Anwenden der Erfindung herbeigeführten reliefartig strukturierten Siliciumoberflächen.

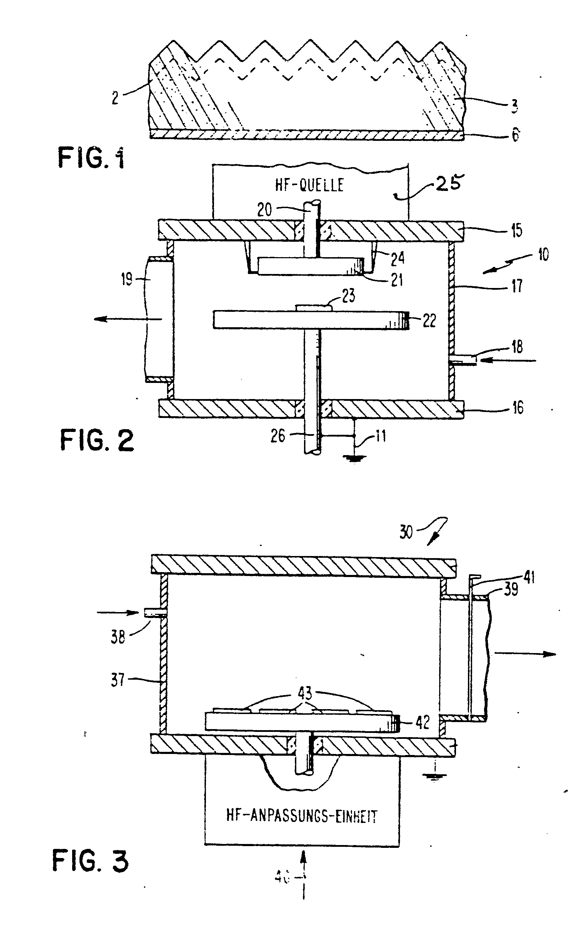

Die in Fig. 1 angedeutete gezackte Oberfläche ist bedingt durch die unter Anwenden des Verfahrens gemäß der Erfindung an der Siliciumhalbleiteroberfläche entstandenen Pyramiden, die einerseits das Oberflächenreflexionsvermögen stark herabdrücken und andererseits zu erhöter Rekombinationsausbeute dank Ladungsträgererzeugung führen, die relativ nahe zum PN-Übergang 2 stattfindet. Wie zuvor schon erwähnt, ist ein derartiger Solarzellentyp an sich bereits mit Hilfe von Naßätzverfahren hergestellt worden. Es versteht sich, daß der in Fig. 1 gezeigte Querschnittsausschnitt schematisiert und zwecks größerer Anschaulichkeit idealisiert dargestellt ist. Es ist jedoch hier hervorzuheben, daß unter Anwenden des erfindungsgemäßen Verfahrens Oberflächenkonfigurationen erzielt worden sind, die der idealisierten Version ziemlich nahe kommen, wobei Abweichungen lediglich durch jeweils verwendete reaktive Gase bedingt sind.

Grundsätzlich besteht die erfindungsgemäß hergestellte Solarzelle aus einem Siliciumsubstrat 3 vom P-Leitfähigkeitstyp, wobei nach Anwenden des erfindungsgemäßen Ätzverfahrens eine Dotierung mit Fremdatomen des N-Leitfähigkeitstyps, vorzugsweise mit Arsen, stattfindet, um im Bereich der Lichteinfallsoberfläche einen PN-Übergang 2 bereitzustellen. Zur Vervollständigung der Solarzelle ist an ihrer unteren Oberfläche eine Elektrode 6 angebracht ; wobei es sich versteht, daß außerdem noch Elektroden bzw. Elektrodenteile an ausgewählten Bereichen der oberen Oberfläche der Solarzelle angebracht sind, die hier jedoch nicht gezeigt sind.

Die mit der erfindungsgemäß hergestellten Solarzelle herbeigeführte erhöhte Ladungsträger-Rekombinationsausbeute stellt ein Ergebnis des herabgedrückten Reflexionsvermögens an der Lichteinfallfläche des Siliciumkörpers dar. Um dieses Reflexionsvermögen noch weiter herabzusetzen, läßt sich zusätzlich noch in an sich bekannter Weise ein Antireflexbelag auf die Lichteinfallsoberfläche des Siliciumkörpers anbringen.

Die Oberflächenbehandlung der Siliciumsubstrate erfolgt, wie bereits gesagt, mit Hilfe reaktiver Ionenätzprozesse. Wie schon ausgeführt, hat sich herausgestellt, daß es erforderlich ist, die Siliciumoberfläche mit reaktiven Ionen zu bombardieren, um die angestrebten Ergebnisse zu erzielen. Hierzu brauchbare Trockenätzsysteme sind allgemein unter der Bezeichnung Diodenstrecken-Gasentladungskammern bekannt, obgleich an sich auch Triodensysteme ebenso wirkungsvoll sein können. Zwei Ausführungsbeispiele von für die Erfindung zweckmäßigen Diodenstrecken-Gasentladungskammern sind im Querschnitt in Fig. 2 und 3 gezeigt.

Fig. 2 zeigt einen Planar-Diodenstrecken-Plasmareaktor, bestehend aus einer Niederdruckgas-Ionisationskammer 10, an die sich eine abgeschirmte Hochfrequenz-Quelle anschließt. Über Zuleitung 11 liegt diese Kammer an Masse. Die Ionisationskammer 10 selbst besteht aus einer metallischen Wandung 17, die durch die Metallplatten 15 und 16 abgeschlossen ist. Die Ionisationskammer 10 ist in typischer Weise aus Aluminium oder rostfreiem Stahl mit Aluminiumeinlage hergestellt. Ein geeignetes Plasmaätzgas wird in die Ionisationskammer 10 über Einlaßstutzen 18 eingeführt und läßt sich aus der Ionisationskammer 10 mittels einer hier nicht gezeigten Hochvakuumpumpe über Auslaßstutzen 19 abziehen. Innerhalb der Ionisationskammer 10 befindet sich eine Anode 22, die in typischer Weise aus rostfreiem Stahl besteht. Die Anode 22 liegt über ihr Stützrohr 26 ebenfalls an Masse. Über dieses Stützrohr 26 wird außerdem noch die Kühlflüssigkeit an die Anode geführt. Auf der Anode 22 befindet sich eine Siliciumscheibe 23, die gemäß der Erfindung reliefartig zu strukturieren ist.

In der Nachbarschaft der Anode 22 befindet sich eine Kathode 21. In typischer Weise enthält die Kathode 21 eine auf eine Kupferkathode fest angebrachte Quarzschicht. Eine rostfreie Stahlabschirmung 24 umgibt die Kathode 21 und dient zur Unterdrückung unerwünschter Glimmentladung, die sonst auch hinter der eigentlich benutzten Kathodenfläche stattfinden kann. In einem praktisch verwendeten System hat die Kathode einen Durchmesser von etwa 19 cm und die Anode einen Durchmesser von etwa 25 cm besessen, während der Abstand zwischen beiden Elektroden etwa 8,6 cm betragen hat.

Über die gegenüber der Abschlußplatte 15 isolierte Zuführung 20 ist die Hochfrequenz-Quelle 25 mit der Kathode verbunden, wobei die Zuführung 20 außerdem noch für die Zuführung der Kühlflüssigkeit an die Kathode ausgestaltet ist. Oben beschriebene Plasmaätzanlage ist im übrigen im Handel erhältlich.

Mit Fig. 3 ist eine Kathodenzerstäubungsanlage gezeigt, mit der sich ein beträchtliches Ionenbombardement auf hierin eingebrachte Halbleiterscheiben erzielen läßt. Wird ein Reaktionsgas, wie z.B. $CF_4$ gemischt mit $O_2$, in die Gasentladungskammer eingeführt und hierin eine Glimmentladung herbeigeführt, dann ergibt sich gerichtetes Ätzen, was zu einer reliefartigen Strukturierung von Siliciumoberflächen führt. Bei einer derartigen Anlage wirkt die gesamte Entladungskammer 30 als Anode, wobei die Siliciumhalbleiterscheiben 43 auf einer Kathode 42 angebracht sind, die ihrerseits über ein HF-Anpassungsgerät an eine Hochfrequenz-Quelle 40 angeschlossen ist.

An die Wandung 37 der Entladungskammer ist ein Einlaßstutzen 38 für die Entladungsgaszufuhr und ein Auslaßstutzen 39, enthaltend ein Regelventil 41 zur Steuerung der Gasströmung, angeschlossen.

Bei den beiden in Fig. 2 und 3 gezeigten Anlagen ist in praktischer Anwendung des erfindungsgemäßen Verfahrens eine Frequenz von 13,56 MHz eingestellt worden, obgleich ebensogut auch andere Frequenzen Anwendung hätten finden können.

Wie bereits kurz erwähnt, sind in der Praxis alle Versuche fehlgeschlagen, reflexmindernde Oberflächen auf Silicium-halbleiter hervorzurufen, wenn Trockenätzsysteme Benutzung gefunden haben, die nicht dazu eingerichtet gewesen sind, sowohl ein beträchtliches Ionenbombardement auf die Halbleiterscheiben auszuüben, als auch gleichzeitig eine chemische Reaktion des Prozeßgases mit der zu behandelnden Halbleiteroberfläche herbeizuführen, wobei sich ein flüchtiges Reaktionsprodukt ergibt. Eine Apparatur, die sich in dieser Hinsicht als nicht erfolgreich erwiesen hat, läßt sich z.B. der US-Patentschrift 38 67 216 entnehmen, deren Ausführungsbeispiel weitgehend einer handelsüblichen Anordnung entspricht. Hiermit ist es, wie sich herausgestellt hat, nicht möglich, reaktive Ionen in ausreichendem Maße zu beschleunigen ; lediglich die Siliciumoberfläche wird hierbei angeätzt. Es hat sich fernerhin gezeigt, daß, wenn überhaupt, hierbei lediglich kleine Gebiete auf der Halbleiterscheibe reliefartig strukturiert worden sind ; wobei im ganzen gesehen das Prozeßergebnis weder gleichförmig noch zufriedenstellend ist.

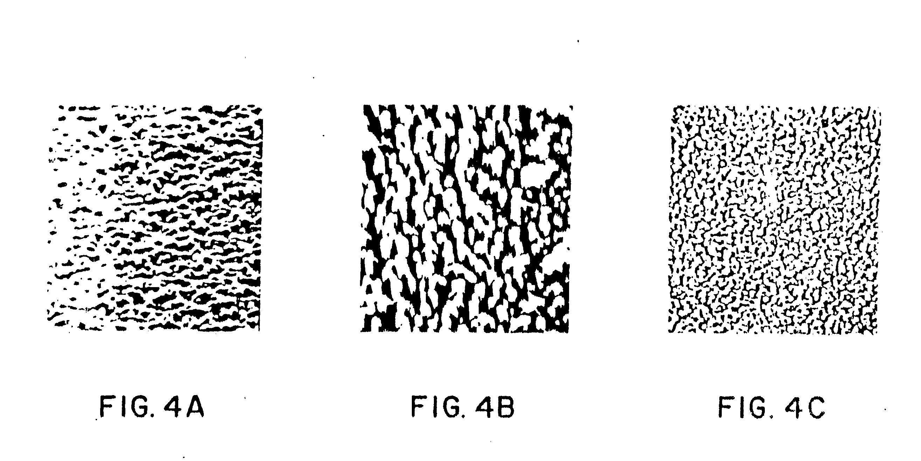

Bei einem Ausführungsbeispiel des erfindungsgemäßen Verfahrens ist eine in Fig. 3 gezeigte Apparatur unter Verwenden einer Gasmischung von Chlor, Argon und Sauerstoff im einen Falle und einer Gasmischung von Chlor und Argon allein im anderen Falle bei Durchflußraten von etwa 20 bis 30 $cm^3$/min angewendet worden. Es haben sich gute Ergebnisse gezeigt. Die Abbildung in Fig. 4A zeigt eine Siliciumoberfläche, die unter Verwenden eines Gasgemischs von Chlor, Argon und Sauerstoff reliefartig strukturiert worden ist. Die Oberfläche erscheint unter Einfall weißen Lichts blau, was als Anzeige dafür dienen kann, daß hiermit ein wirksames Absorptionsmittel für Infrarotstrahlung vorliegt.

In einem anderen Ausführungsbeispiel des erfindungsgemäßen Prozesses ist eine Apparatur gemäß Fig. 2 verwendet worden, indem eine Gasmischung von Chlor mit Argon bei einer Durchflußrate von rund 10 cm³/min Anwendung gefunden hat, um hiermit eine stalaktitenartige Struktur auf der Siliciumhalbleiterscheibe in gleichförmiger Verteilung zu erzielen, wobei die einzelnen « Finger », aus Silicium-Silicium X bestehend, annähernd 1 500 nm hoch und 300 nm breit gewesen sind und die Abstände hierzwischen rund 300 bis 500 nm betragen haben. Eine Abbildung dieser Oberflächenstruktur läßt sich der Fig. 4B entnehmen.

Gasmischungen, bestehend z.B. aus CCl₄ oder DF₄ und anderen Halogenkohlenstoffgasen zusammen mit trägen Gasen, wie z.B. Argon und Helium, dürften ebenfalls gute Kandidaten zur Verwendung in einem erfindungsgemäßen Siliciumoberflächenstrukturierungsverfahren sein.

Bei einem anderen Prozeßausführungsbeispiel gemäß der Erfindung ist ebenfalls ein System gemäß Fig. 2 verwendet worden, das hier allerdings mit einer Gasmischung aus SF₆ und H₂ bei einer Durchflußrate von 8 cm³ bzw. 2 cm³/min betrieben worden ist. Die angelegte HF-Leistung hat etwa 200 W betragen. Der Druck innerhalb der Entladungskammer während des Oberflächenstrukturierungsvorgangs hat bei etwa 0,1 μbar gelegen, während die Dauer des Ätzvorganges etwa 10 Minuten betragen hat. Als Resultat hat sich eine ausgezeichnet gleichförmig geschwärzte Siliciumoberfläche ergeben, die total-nichtreflektierend erschienen ist. Eine Abbildung dieser Oberfläche ist in Fig. 4C gezeigt.

Bei einer anderen Prozeßdurchführung ist ein Gas, bestehend nur aus SF₆ bei gleicher HF-Leistung, Druck in der Entladungskammer und Durchflußrate von 10 cm³/min bei einer Anwendungsdauer zwischen 5 und 10 min verwendet worden. Als Ergebnis hat sich nur eine teilweise Schwärzung der Siliciumoberfläche, ähnlich der einer glanzlosen Schwärzung, ergeben. Das Resultat wurde als weniger zufriedenstellend angesehen als der zuvor beschriebene Prozeß unter Verwenden von SF₆ mit H₂.

Um eine verbesserte Halbleiteroberfläche bei gleichförmigerem PN-Übergang im Silicium zu erhalten, läßt sich während des Strukturierungsprozesses eine nicht-erodierende Metallmaske, wie z.B. Chrom, anwenden. Diese Maske wird mit einer über ihre gesamte Oberfläche ausgebreiteten Porenvielfalt geeigneter Abmessung versehen, wie z.B. Porendurchmesser von 2 μm und Porenabstand von ebenfalls 2 μm. Nach reliefartiger Strukturierung unter Anwenden des erfindungsgemäßen reaktiven Ionenätzprozesses bei Betrieb mit zuvor erwähnten Prozeßgasen haben sich auf der Siliciumoberfläche mehr nahezu konische statt pyramidenförmige Erhebungen gezeigt. Schließlich hat sich gezeigt, daß bei Einbringen eines PN-Übergangs im Anschluß an die reliefartige Strukturierung der Siliciumoberfläche, z.B. mittels Diffusion, die Konturen des PN-Übergangs näher den Oberflächenkonturen folgen.

**Ansprüche**

1. Verfahren zum reliefartigen Strukturieren von Siliciumoberflächen mit Hilfe von Ätzverfahren, um im wesentlichen nicht-reflektierende Oberflächen hierauf zu erhalten, dadurch gekennzeichnet, daß die Oberflächen von Siliciumsubstraten in einer Gasentladungskammer, enthaltend eine chemisch aktive Gasatmosphäre, die mit Silicium eine flüchtige Verbindung einzugehen vermag, unter Einwirkung einer HF-Gasentladung einer reaktiven Ionenätzung ausgesetzt werden, wobei die Zeitdauer dieses Vorgangs so eingestellt wird, daß sich eine reliefartige Strukturierung der Siliciumoberfläche ergibt.

2. Verfahren nach Anspruch 1, dadurch gekennzeichnet, daß die reaktive Ionenätzung in einer Niederdruck-Ionisationskammer (10) durchgeführt wird, die eine Anode (22) sowie eine von der Kammerwandung isolierte, mit einer Abschirmung (24) versenene und miteiner direkt an der Ionisationskammer (10) angebrachten HF-Quelle (25) unmittelbar verbundene Kathode (21) enthält (Fig. 2).

3. Verfahren nach Anspruch 1, dadurch gekennzeichnet, daß die reaktive Ionenätzung mittels einer Kathodenzerstäubungsanlage (30), bei der die Kammerwandung gleichzeitig als Anode dient, vorgenommen wird und in welcher die Siliciumsubstrate (43) auf . einer von der Kammerwandung isolierten, über ein HF-Anpassungsgerät mit einer HF-Quelle (40) gekoppelten Kathode (42) angebracht werden (Fig. 3).

4. Verfahren nach Anspruch 1, dadurch gekennzeichnet, daß eine Gasatmosphäre, bestehend aus einer Mischung von SF₆ und H₂, in der Gasentladungskammer zur Einwirkung gebracht wird.

5. Verfahren nach den Ansprüchen 1 bis 3, dadurch gekennzeichnet, daß in der Gasentladungskammer eine Prozeßgasatmosphäre, bestehend aus einer Mischung von Chlor, Argon und Sauerstoff, zur Einwirkung gebracht wird.

6. Verfahren nach den Ansprüchen 1 bis 3, dadurch gekennzeichnet, daß in der Gasentladungskammer eine Prozeßgasatmosphäre, bestehend aus ClAr₃, zur Einwirkung gebracht wird.

7. Verfahren nach den Ansprüchen 1 bis 3, dadurch gekennzeichnet, daß in der Gasentladungskammer eine Prozeßgasatmosphäre, bestehend aus einem Halogen-Kohlenstoffgas, zur Einwirkung gebracht wird, das geeignet ist, mit Silicium eine flüchtige Verbindung einzugehen.

**Claims**

1. Method for the relief-like structuring of silicon surfaces by means of etching processes to obtain substantially non-reflecting surfaces thereon, characterized in that the surfaces of silicon substrates are exposed in a gas discharge chamber containing a chemically active gaseous atmosphere that can combine with a silicon to form a volatile compound, to a reactive ion etching under the influence of an RF gas discharge, the duration of this process being fixed in such a manner that a relief-like structuring of the silicon surfaces is obtained.

2. Method as claimed in claim 1, characterized in that the reactive ion etching is carried out in a low pressure ionization chamber (10) which contains an anode (22) as well as a cathode (21) that is insulated from the chamber wall, equipped with a screen (24), and directly connected to an RF source (25) which is directly connected to the ion chamber (20) (Fig. 2).

3. Method as claimed in claim 1, characterized in that the reactive ion etching is effected by means of a cathode sputtering system (30) where the chamber wall is also used as an anode, and wherein the silicon substrates (43) are applied on a cathode (42) insulated from the chamber wall, and coupled via an RF adaptor to an RF source (40) (Fig. 3).

4. Method as claimed in claim 1, characterized in that a process gas atmosphere consisting of a mixture of $SF_6$ and $H_2$ is placed in the gas discharge chamber.

5. Method as claimed in claims 1 to 3, characterized in that a process gas atmosphere consisting of a mixture of chloron, argon and oxygen is placed in the gas discharge chamber.

6. Method as claimed in claims 1 to 3, characterized in that a process gas atmosphere consisting of $ClAr_3$ is placed in the gas discharge chamber.

7. Method as claimed in claims 1 to 3, characterized in that a process gas atmosphere consisting of a halogen-carbon gas which can combine with silicon to form a volatile compound is placed in the gas discharge chamber.

**Revendications**

1. Procédé pour réaliser des structurations en relief aux surfaces des substrats en silicium à l'aide d'un procédé de décapage afin d'obtenir sur celle-ci des surfaces essentiellement non réfléchissantes, caractérisé en ce que les surfaces des substrats de silicium sont exposées, dans une chambre à décharge à une atmosphère de gaz chimiquement actif pouvant former avec le silicium un composé volatil où elles sont soumises à un décapage par ions réactifs sous l'influence d'une décharge de gaz de haute fréquence, la durée de ce processus étant réglée de telle sorte qu'on obtient une structuration en relief des surfaces de silicium.

2. Procédé selon la revendication 1, caractérisé en ce que le décapage par ions réactifs a lieu dans une chambre de ionisation à pression faible (10) qui comporte : une anode (22) ainsi qu'une cathode (21) isolée de la paroi de chambre ayant un écran (24) et étant directement connectée à une source de tension haute fréquence (25) (figure 2), laquelle est directement montée à la chambre d'ionisation (20).

3. Procédé selon la revendication 1, caractérisé en ce que le décapage par ions réactifs est effectué à l'aide d'un système de pulvérisation cathodique (30) dont la paroi de la chambre sert également d'anode ; et dans lequel les substrats de silicium (43) sont déposés sur une cathode (42) isolée de la paroi et qui est couplée à une source de tension haute fréquence (40) à l'aide d'un adaptateur haute fréquence (figure 3).

4. Procédé selon la revendication 1, caractérisé en ce qu'une atmosphère de gaz formée d'un mélange de $SF_6$ et de $H_2$ est laissée agir dans la chambre à décharge.

5. Procédé selon les revendications 1 à 3, caractérisé en ce qu'une atmosphère de gaz de procédé formée d'un mélange de chlore, d'argon et d'oxygène est laissée agir dans la chambre à décharge.

6. Procédé selon les revendications 1 à 3, caractérisé en ce qu'une atmosphère de gaz de procédé formée de $ClAr_3$ est laissée agir dans la chambre de décharge.

7. Procédé selon les revendications 1 à 3, caractérisé en ce qu'une atmosphère de gaz de procédé composée d'un gaz halogène-carbone est laissée agir dans la chambre à décharge, ce gaz pouvant se combiner avec du silicium pour former un composé volatil.

FIG. 1

HF-QUELLE

FIG. 2

HF-ANPASSUNGS-EINHEIT

FIG. 3

1

FIG. 4A          FIG. 4B          FIG. 4C